Europäisches Patentamt

European Patent Office

Office européen des brevets

(11) Publication number: **0 188 080**
**B1**

(12) # EUROPEAN PATENT SPECIFICATION

(45) Date of publication of patent specification: **16.08.90**

(21) Application number: **85308679.1**

(22) Date of filing: **28.11.85**

(51) Int. Cl.⁵: **H 01 L 33/00,** H 01 L 29/205, H 01 S 3/19

(54) **Light-emitting semiconductor device having a super lattice.**

(30) Priority: **07.12.84 JP 259571/84**

(43) Date of publication of application:
**23.07.86 Bulletin 86/30**

(45) Publication of the grant of the patent:
**16.08.90 Bulletin 90/33**

(84) Designated Contracting States:
**DE GB NL**

(56) References cited:
EP-A-0 124 924      US-A-4 205 329

ELECTRONICS LETTERS, vol. 19, no. 5, 3rd March 1983, pages 163-165, London, GB; Y. KAWAMURA et al.: "0.66 my room-temperature operation of In GaAlP DH laser diodes grown by MBE"

I.E.E.E. ELECTRON DEVICE LETTERS, vol. EDL-4, no. 7, July 1983, pages 212-214, New York, US; W.D. LAIDIG et al.: "All-binary AlAs-GaAs laser diode"

JAPANESE JOURNAL OF APPLIED PHYSICS, vol. 22, no. 11, part 2, November 1983, pages 680-682, Tokyo, JP; T. YAO "A new high-electron mobility monolayer superlattice"

(73) Proprietor: **SHARP KABUSHIKI KAISHA**
**22-22 Nagaike-cho Abeno-ku**
**Osaka 545 (JP)**

(72) Inventor: **Hayakawa, Toshiro**
**17-402, Katsuragi-cho**
**Nara-shi Nara-ken (JP)**
Inventor: **Suyama, Takahiro**
**2613-1, Ichinomoto-cho**
**Tenri-shi Nara-ken (JP)**
Inventor: **Takahashi, Kohsei**
**2613-1, Ichinomoto-cho**
**Tenri-shi Nara-ken (JP)**
Inventor: **Yamamoto, Saburo**
**1-2-11, Akanedai Haibara-cho**
**Uda-gun Nara-ken (JP)**

(74) Representative: **Kosmin, Gerald Emmanuel et al**
**HASELTINE, LAKE & CO. Hazlitt House 28**
**Southampton Buildings Chancery Lane**
**London, WC2A 1AT (GB)**

## Description

This invention relates to a high efficiency optical semiconductor device, such as a semiconductor laser device and a light emitting diode, which emits light having a wavelength of less than 700 nm and which utilizes the quantum effect in the light emitting region.

In recent years, movement toward the development of an "information society" is rapid, and particularly conspicuous has been development of optical information processing techniques such as optical discs, etc., which are based on optical devices incorporating semiconductor laser devices and light-emitting diodes. In these circumstances, optical devices which emit light having a wavelength in the visible region are required, and particularly high expectations exist for visible semiconductor laser devices. At the present, GaAlAs system semiconductor laser devices having an oscillation wavelength of 780 nm are in practical use as light sources for compact discs and video discs. In order to be able to handle a greater amount of information, it is necessary for the diameter of the focused beams to be decreased, and accordingly, semiconductor laser devices generating a shorter wavelength of light are required.

It is known from IEEE Electron Device Letters, Vol. EDL-4 (1983), July No. 7, pp. 212—214 to use a superlattice of thin layers of AlAs and GaAs to simulate the properties of $Al_xGa_{1-x}As$ for use as a cladding layer in a laser diode, whilst from Japanese Journal of Applied Physics, Vol. 22, No. 11, Part 2, November 1983, pp L680—682, it is known to form a monolayer superlattice from alternating InAs and GaAs monolayers having physical properties analogous to those of the equivalent $In_{0.5}Ga_{0.5}As$ alloy when the periodicity of the monolayer superlattice is less than 16 monolayers.

In recently published EP—A—124924 there is disclosed a semiconductor laser device having an active layer-shaped semiconductor region comprising a superlattice structure composed of n monolayered active layers which may be formed from GaP and m monolayered barrier layers which may be formed from AlP, where n and m are integers satisfying the conditions:

$$2 \leqslant n \leqslant 7, \ 2 \leqslant m \leqslant 7 \ \text{ and } \ n+m \leqslant 12.$$

As a semiconductor material with an energy gap that corresponds to the above-mentioned region,

$$(Al_xGa_{1-x})_yIn_{1-y}P,$$

the lattice constant of which is matched to the lattice constant of a GaAs substrate, is receiving some attention (see for example Electronic Letters, Vol. 19 (1983), No. 5, pp 163—165). Because there are some difficulties with the growth of this material in the current liquid-phase epitaxial method, the newest methods available, molecular beam epitaxy (MBE) and metal-organic chemical vapor deposition (MO-CVD) using organometallic compounds, are being much studied for application with this material. With MBE and MO-CVD, growth occurs depending upon the transport limit. The

$$(Al_xGa_{1-x})_yIn_{1-y}P$$

system contains three elements in Group 3 of the Periodic Table, so that if the proportions y of In, Al, and Ga are changed from the fixed value, the mis-match of the lattice thereof to that of the GaAs substrate become noticeable, and crystals of good quality cannot be obtained. Therefore, it is necessary to control the proportions of Al, Ga and In to within 0.1%, which calls for high accuracy. However, this is not necessarily easy if the considerations of distribution of this material within the wafer surface and reproducibility are added.

In addition, since it is possible by MBE and/or MO-CVD to have a growth speed of less than 1 μm/h, it is feasible to control the thickness of thin single crystals. In particular, by MBE, control of the order of layers of monomolecules can be achieved. Thus, MBE and MO-CVD allow the production of the active region of semiconductor laser devices in extremely thin layers, less than 10 nm (100 Å), thereby allowing for stepwise changes in the density of the carrier, and enabling the production of a quantum well (QW) laser with a lowered threshold. It is conceivable that such a quantum well laser might be manufactured using

$$(Al_xGa_{1-x})_yIn_{1-y}P.$$

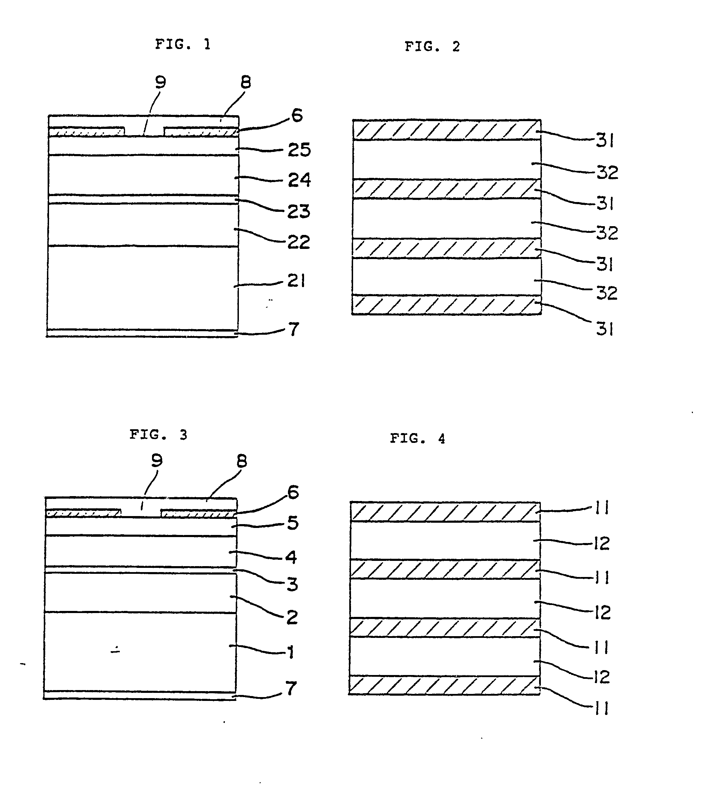

For example, as shown in Figure 3, on an n-GaAs substrate 1, an

$$n\text{-}(Al_{0.6}Ga_{0.4})_{0.5}In_{0.5}P$$

cladding layer (the thickness thereof being 1 μm) 2, a non-doped multi-quantum well (MQW) active layer 3, a

$$p\text{-}(Al_{0.6}Ga_{0.4})_{0.5}In_{0.5}P$$

cladding layer (the thickness thereof being 1 μm) 4 and a p-GaAs cap layer 5 could be successively grown by MBE, followed by the formation of a $SiO_2$ film 6 on the cap layer 5. A stripe 9 could be formed on the $SiO_2$ film 6 by photolithography, etc., and then ohmic contacts 7 and 8 could be formed, resulting in an oxide film striped laser device. The MQW active layer 3 would be composed of alternate layers consisting of, as shown in Figure 4, four non-doped

$$(Al_{0.15}Ga_{0.85})_{0.5}In_{0.5}P$$

well layers (the thickness thereof being 5 nm (50 Å) 11 and three non-doped

$(Al_{0.4}Ga_{0.6})_{0.5}In_{0.5}P$

barrier layers (the thickness thereof being 10 nm (100 Å) 12. In a QW laser with these components, in order for the lattice thereof to almost completely match that of GaAs, the semiconductors of the cladding layers 2 and 4, of the well layer 11, and of the barrier layer 12 must all be mixed crystals. Therefore, in the QW laser, it would be necessary to confine the carriers by a well-shaped potential made in well layer 11. When mixed crystals are used, the chemical compounds (AlP, GaP and InP) that are the basis of the mixed crystals should be randomly mixed, resulting in fluctuations in the potential in the direction within the surface of the interface making up the quantum well, so that an ideal quantum well can not be achieved causing decreased operation efficiency. Moreover, if the well layer 11 and the barrier layer 12 are thin, this phenomenon will be more noticeable, and the problem of fluctuation resulting from mixed crystals within the well layer 11 and the barrier layer 12 will occur.

In accordance with the present invention, there is provided an optical semiconductor device including a multi-quantum well active region for generating optical radiation, characterised in that the active region comprises alternating well layers and barrier layers with the barrier layers having a larger energy gap than the well layers, each of the layers comprising a lamination of molecular layers of InP, GaP and AlP with each InP molecular layer being composed of a continuous lamination of twenty or fewer monomolecular layers.

The ratio of the number of the InP molecular layers to the total number of the GaP molecular layers and the AlP molecular layers in each of said molecular layers is, in a preferred embodiment, in the range of 1:1 to 12:13.

Each InP molecular layer is, in a preferred embodiment, composed of a single monomolecular layer, and advantageously each of the InP, GaP and AlP layers is composed of a single monomolecular layer.

Thus, the invention described herein makes it possible to (1) provide an optical semiconductor device in which molecular layer units composed of binary compound semiconductors of InP, GaP and AlP are laminated on a GaAs substrate in an ordered arrangement, so that neither scattering of light nor fluctuation in potential based on a disordered arrangement of molecular layers occurs and a high operation efficiency and an excellent operation reliability can be attained; and (2) provide an optical semiconductor device in which a suppression of the quantum effect due to noticeable fluctuation in potential which is essential to mixed crystal semiconductors of polycomponents, is eliminated thereby attaining a high operation efficiency and excellent operation reliability.

For a better understanding of the invention and to show how the same may be carried into effect, reference will now be made, by way of example, to the accompanying drawings, in which:

Figure 1 is a sectional front view showing a multi-quantum well (MQW) semiconductor laser device of this invention;

Figure 2 is a sectional front view showing the active layer 23 of the semiconductor laser device shown in Figure 1;

Figure 3 is a sectional view showing a MQW semiconductor laser device as conceived by the present inventors; and

Figure 4 is a sectional front view showing the active layer 3 of the semiconductor laser device shown in Figure 3.

Referring now to the drawings, Figure 1 shows a multi-quantum well (MQW) semiconductor laser device of this invention, which is produced as follows: On an n-GaAs substrate 21, an

$n\text{-}(AlP)_3(GaP)_2(InP)_5$

superlatticed cladding layer (the thickness thereof being 1 μm) 22, a non-doped superlatticed MQW active layer (the thickness thereof being approximately 59 nm (590 Å)) 23, a

$p\text{-}(AlP)_3(GaP)_2(InP)_5$

superlatticed cladding layer (the thickness thereof being 1 μm) 24, and a p-GaAs cap layer (the thickness thereof being 0.5 μm) 25 are successively grown by MBE, by which monomolecular layers are laminated for each layer with a monitor of the changes in the RHEED strength, followed by the formation of a SiO₂ film 6 in the same manner as in the laser device shown in Figure 3. Then, a stripe 9 is formed on the SiO₂ film 6, and ohmic contacts 7 and 8 are formed, resulting in an oxide film striped laser device. In order to minimize the influence of a lattice distortion on the differences in the lattice constant between the InP layer and the GaP layer and beteen the InP layer and the AlP layer, the above-mentioned

$(AlP)_3(GaP)_2(InP)_5$

cladding layers 22 and 24, respectively, are designed to be composed of units of a laminated layer structure composed of (InP) (AlP) (InP) (GaP) (InP) (AlP) (InP) (GaP) (InP) (AlP) in sequence. Each of the (InP), (AlP) and (GaP) layers therein is a monomolecular layer. Figure 2 shows the structure of the MOW active layer 23, which is composed of alternate layers consisting of four

$Q(AlP)_1(GaP)_5\ (InP)_6$

well layers 31 and three

$(AlP)_2(GaP)_3(InP)_5$

barrier layers 32. The

$(AlP)_1(GaP)_5(InP)_6$

well layer 31 is composed of the lamination (the thickness thereof being approximately 6.8 nm (68

Å) of two layers units, each of which is composed of (InP) (GaP) (InP) (GaP) (InP) (AlP) (InP) (GaP) (InP) (GaP) (InP) (GaP) in sequence. Each of the (InP), (AlP) and (GaP) layers therein is also a monomolecular layer. The

$$(AlP)_2(GaP)_3(InP)_5$$

barrier layer 32 is composed of the lamination (the thickness thereof being approximately 10.5 nm (105 Å)) of four layer units, each of which is composed of (InP) (GaP) (InP) (AlP) (InP) (GaP) (InP) (AlP) (InP) (GaP) in sequence. Each of the (InP), (AlP) and (GaP) layers therein is also a monomolecular layer.

The resulting superlatticed MQW laser device composed of monomolecular layers as layer units is equivalent to a MQW laser device composed of mixed crystals of

$$(Al_{0.6}Ga_{0.4})_{0.5}In_{0.5}P$$

as the cladding layers 22 and 24,

$$(Al_{0.17}Ga_{0.83})_{0.5}In_{0.5}P$$

as the well layer 31 and

$$(Al_{0.4}Ga_{0.6})_{0.5}In_{0.5}P$$

as the barrier layer 32. The atoms of Al, Ga and In in the above-mentioned superlatticed MQW laser device of this invention are arranged in order, resulting in an ideal multi-quantum well, in which neither the scattering of light nor fluctuation in quantum well potential based on the disordered arrangement of the atoms occur. In particular, the interface between the well layer 31 and the barrier layer 32 clearly exists as an interface between the InP monomolecular layer and the GaP monomolecular layer. Moreover, the interface between the well layer 31 and the cladding layer 22 and the interface between the well layer 31 and the cladding layer 24, respectively, form the interface between the AlP monomolecular layer and the InP monomolecular layer and the interface between the GaP monomolecular layer and the InP monomolecular layer, as well. Therefore, irregularities of the potential at the interfaces never arise.

Another feature of a preferred embodiment of this invention is that in laminating the InP monomolecular layers, the lattice constant of which is quite different from that of the GaAs substrate, the AlP monomolecular layers and the GaP monomolecular layers, both the lattice constants of which are nearly equal to that of the GaAs substrate, on the GaAs substrate, each InP layer is composed of a continuous lamination of less than two monomolecular layers (i.e., one InP layer consists of a single monomolecular layer which is the minimum layer unit) to thereby avoid distortion resulting from a difference in the lattice constant between the InP layer and the GaAs substrate, so that the resulting superlattice can be prevented from undergoing such a rapid deterioration in laser operation that conventional distorted superlattices of GaAsP systems or InGaAs systems undergo. In practice, when the InP layer is composed of the continuous lamination of twenty or fewer molecular layers, the lattice distortion is so small that the resulting superlattice will undergo no deterioration. In this example of the present invention, the ratio or the number of the InP molecular layers to the total number of the GaP molecular layers and the AlP molecular layers is selected to be 1:1, thereby attaining a good match of the lattice constants between these molecular layers and the GaAs substrate 21. Even though this ratio is set to be in the range of 1:1 to 12:13, the good match of the lattice constants therebetween can be attained with a great accuracy.

Although the above-mentioned example of this invention concerns the MQW semiconductor laser device, this invention can be applied to other semiconductor laser structures using conventional AlGaInP mixed crystal semiconductors, light emitting diodes, etc.

**Claims**

1. An optical semiconductor device including a multi-quantum well active region (23) for generating optical radiation, characterised in that the active region (23) comprises alternating well layers (31) and barrier layers (32) with the barrier layers (32) having a larger energy gap than the well layers (31), each of the layers (31, 32) comprising a lamination of molecular layers of InP, GaP and AlP with each InP molecular layer being composed of a continuous lamination of twenty or fewer monomolecular layers.

2. An optical semiconductor device as claimed in Claim 1, wherein the ratio of the number of the InP molecular layers to the total number of the GaP molecular layers and the AlP molecular layers in each of said laminations is in the range of 1:1 to 12:13.

3. An optical semiconductor device as claimed in Claim 1 or 2, wherein each of the InP layers is composed of a single monomolecular layer.

4. An optical semiconductor device as claimed in Claim 1 or 2, wherein each of the InP, GaP and AlP layers is composed of a single monomolecular layer.

**Patentansprüche**

1. Optische Halbleitereinrichtung mit einem aktiven Bereich (23) in Form eines Mehrfachquantentrogs zur Erzeugung einer optischen Strahlung, dadurch gekennzeichnet, daß der aktive Bereich (23) abwechselnd Trogschichten (31) und Barriereschichten (32) aufweist, wobei die Barriereschichten (32) einen größeren Energieabstand als die Trogschichten (31) haben, und wobei jede der Schichten (31, 32) eine Schichtung von Molekularschichten aus InP, GaP und AlP aufweist, wobei jede InP-Molekularschicht auf einer zusammenhängenden Schichtung von zwanzig oder weniger monomolekularen Schichten besteht.

2. Optische Halbleitereinrichtung nach Anspruch 1, wobei das Verhältnis der Anzahl der InP-Molekularschichten zu der Gesamtzahl der GaP-Molekularschichten und den AlP-Molekularschichten in jeder der Schichtungen im Bereich von 1:1 bis 12:13 liegt.

3. Optische Halbleitereinrichtung nach Anspruch 1 oder 2, wobei jede der InP-Schichten aus einer einzigen monomolekularen Schicht gebildet ist.

4. Optische Halbleitereinrichtung nach Anspruch 1 oder 2, wobei jede der InP, GaP und AlP Schichten aus einer einzigen monomolekularen Schicht gebildet ist.

**Revendications**

1. Dispositif optique à semi-conducteur, comprenant une région active de puits multiquantique (23) permettant d'émettre un rayonnement optique, caractérisé en ce que cette région active (23) comprend des couches de puits (31) et des couches d'arrêt (32) qui alternent, les couches d'arrêt (32) possédant une largeur de bande interdite plus grande que les couches de puits (31), chacune des couches (31, 32) étant constituée par une superposition stratifiée de couches moléculaires InP, GaP et AlP, chaque couche moléculaire InP étant constituée d'une superposition stratifiée continue de vingt couches monomoléculaires ou moins.

2. Dispositif optique à semi-conducteur suivant la revendication 1, dans lequel le rapport du nombre des couches moléculaires InP au nombre total des couches moléculaires GaP et des couches moléculaires AlP de chacune des superpositions stratifiées est dans la gamme de valeurs de 1:1 à 12:13.

3. Dispositif optique à semi-conducteur suivant la revendication 1 ou 2, dans lequel chacune des couches InP est constituée d'une couche monomoléculaire unique.

4. Dispositif optique à semi-conducteur suivant la revendication 1 ou 2, dans lequel chacune des couches InP, GaP et AlP est constituée d'une couche monomoléculaire unique.

FIG. 1

FIG. 2

FIG. 3

FIG. 4